# EUROPÄISCHE PATENTSCHRIFT

(11) **EP 2 348 554 B1**
(45) Veröffentlichungstag und Bekanntmachung des Hinweises auf die Patenterteilung: **03.06.2015**
(21) Anmeldenummer: 10197265.1
(22) Anmeldetag: 29.12.2010
(51) Int. Cl.: H01L 41/257, H01L 41/083

(54) **Verfahren zur Herstellung eines Piezoaktors mit einem Mehrlagenaufbau von Piezolagen**
Method for producing a piezo actuator with a multi-layer structure of piezo layers
Procédé de fabrication d'un piézoactionneur doté d'une structure en plusieurs couches

(30) Priorität: 26.01.2010 DE 102010001224
(43) Veröffentlichungstag der Anmeldung: 27.07.2011
(73) Patentinhaber: Robert Bosch GmbH, 70442 Stuttgart (DE)
(72) Erfinder: Cromme, Peter, 96050, Bamberg (DE)

(56) Entgegenhaltungen:
- WO-A1-2005/006457
- DE-A1- 3 344 296
- DE-A1- 10 232 311
- DE-B1- 1 466 189
- GB-A- 1 090 037
- US-A- 3 108 211
- US-A- 3 365 633

## Beschreibung

### Stand der Technik

Die Erfindung betrifft ein Verfahren zur Herstellung eines Piezoaktors mit einem Mehrlagenaufbau von Piezolagen nach den gattungsgemäßen Merkmalen des Anspruchs 1. An sich bekannt sind Piezoaktoren als piezoelektrische Bauteile und Verfahren zu deren Herstellungen bekannt, die insbesondere bei Brennstoffeinspritzanlagen von luftverdichtenden, selbstzündenden Brennkraftmaschinen angewendet werden. Diese auch Piezoinjektor genannte Ausführung besteht im wesentlichen aus einem Haltekörper und einem in dem Haltekörper angeordneten Piezoaktormodul, bestehend aus einem Kopf- und einem Fußteil sowie einem zwischen Kopf- und Fußteil angeordneten Piezoaktor aus den Piezoelementen. Das Piezoaktormodul ist hier dann mit einer Düsennadel verbunden, sodass durch Anlegen oder Wegnahme einer elektrischen Spannung an die Piezoelemente eine Düsenöffnung freigegeben oder verschlossen wird. Bei der so genannten direkten Düsennadelsteuerung wird der Piezoaktor im Haltekörper des Piezoinjektors direkt im Kraftstoff unter Hochdruck betrieben. Ein Piezoinjektor mit direkter Düsennadelsteuerung ist beispielsweise aus der EP 117 46 15 A2 bekannt. Die Piezoelemente des bekannten Piezoaktors sind aus Piezolagen aus einem Material mit einer geeigneten Kristallstruktur so aufgebaut, dass beim Anlegen einer äußeren elektrischen Spannung an Innenelektroden, die die Piezolagen jeweils einschließen, eine mechanische Reaktion der Piezoelemente erfolgt. Um mit moderaten elektrischen Spannungen in Kraftfahrzeugen arbeiten zu können, wird daher in der Regel ein Mehrlagenaufbau verwendet, der einen Schichtverbund aus dünnen Keramikschichten und metallischen Innenelektroden darstellt. Hierbei wird ein alternierendes (interdigitales) Innenelektrodendesign angewendet, bei dem die Innenelektroden wechselseitig aus dem Mehrlagenaufbau herausgeführt werden und über Außenelektroden polaritätsabhängig elektrisch parallel geschaltet sind. Wird nun eine elektrische Spannung an die Außenelektroden angelegt, führen die piezoelektrischen Lagen jeweils eine kleine Hubbewegung in Richtung des Potenzialgefälles aus, die sich zum Gesamthub des Piezoaktors addieren. Der Polarisationszustand der einzelnen Piezolagen bestimmt dabei entscheidend die Eigenschaften des Piezoaktors wie z. B. Hubvermögen, Energieverlust, Kapazität etc.

Es ist hierbei üblich, dass während der Herstellung der Piezoaktoren die Domänen des Materials der Piezolagen durch sogenanntes Heißpolen bei erhöhter Temperatur ausgerichtet bzw. vorausgerichtet werden.

Zur Polarisation des Piezoaktors wird dabei an die Außenelektroden ein elektrisches Polarisationsfeld angelegt, wodurch sich eine permanente Polarisation und eine geordnete Verteilung der elektrischen Dipole in dem Gefüge bzw. dem Kristall der Piezokeramik mit ausgerichteten Domänen gegenüber dem unpolarisierten Ausgangszustand ergibt. Bei dem erwähnten Heißpolarisieren wird somit an den Piezoaktor oberhalb der Curietemperatur ein elektrisches Feld angelegt und dann wird der Piezoaktor auf Raumtemperatur abgekühlt. Kapp unterhalb der Curietemperatur weisen die Domänen dabei eine maximale Beweglichkeit auf, entsprechend genügt für die Polarisation bereits eine Feldstarke von 0,3 KV/mm anstatt der sonst erforderlichen Feldstarken von >2 KV/mm bei Raumtemperatur.

Das bekannte Verfahren weist allerdings vor allem deswegen einen Nachteil auf, da neben der Orientierung von Domänen, insbesondere bei hohen Temperaturen, auch Defekte in der Piezokeramik ausgerichtet werden. Die ausgerichteten Defekte bilden in der Keramik ein sog. Depolarisationfeld, welches entgegen dem elektrischen Feld beim Betrieb des Piezoaktors wirkt.

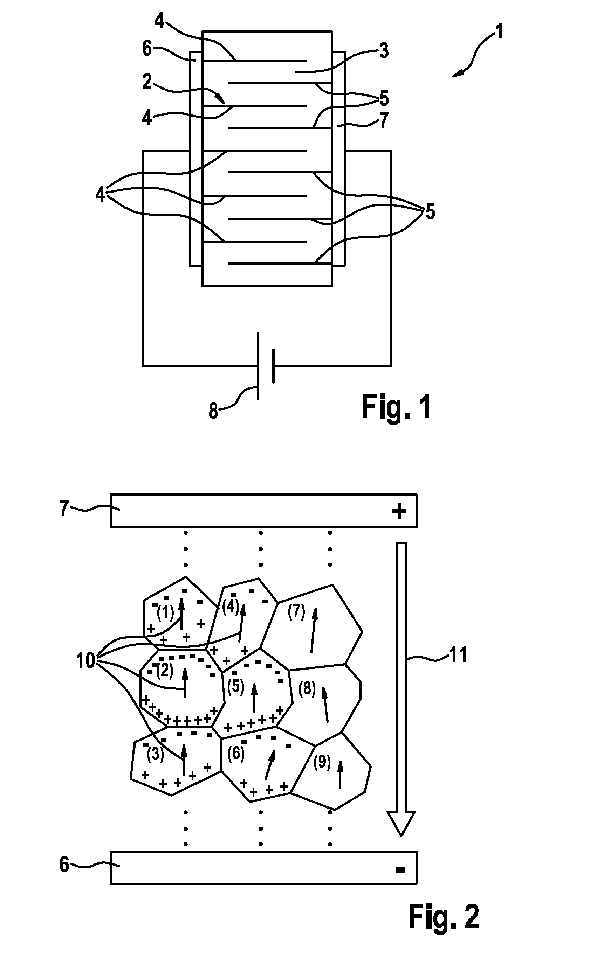

Ursächlich für die Ausbildung von solchen Depolarisationsfeldern beim Heißpolen ist vor allem die Migration von Defekten (Sauerstoffleerstellen, lonen etc.) in der Piezokeramik, wobei der Temperaturbereich über der Curietemperatur bzw. knapp darunter besonders kritisch ist. Hier weisen diese Defekte eine hohe Mobilität auf und können sehr leicht durch das angelegte Polarisationsfeld, wie es in Figur 1 dargestellt ist, ausgerichtet werden. Mit dem Abkühlen des Piezoaktors nimmt die Mobilität der Defekte stark ab, die Orientierung der Defekte verbleibt aber dauerhaft bestehen. Daher weist der Piezoaktor, auch bei einer Anwendung in einem Piezoinjektor, eine reduzierte piezoelektrische Aktivität auf. Eine solche reduzierte piezoelektrische Aktivität (Aktorhub) ist eine Hauptursache für einen Verlust an Wertschöpfung bei der Herstellung der Piezoaktoren.

Bekannte Verfahren werden in WO 2005/006457 A1, DE 102 32 311 A1, DE 33 44 296 A1, US 3 108 211, DE 1 466 189, GB 1 090 037 und US 3 365 633 beschrieben.

### Offenbarung der Erfindung

Die Erfindung geht von einem Verfahren zur Herstellung eines Piezoaktors mit einem Mehrlagenaufbau aus Piezoelementen aus, die jeweils aus Piezolagen aus keramischem Material bestehen, die zwischen Innenelektroden eingefasst sind und die in Richtung des Lagenaufbaus und der Wirkrichtung des Piezoaktors über Außenelektroden abwechselnd mit einer unterschiedlichen Polarität einer elektrischen Spannung beaufschlagbar sind. Gemäß der Erfindung wird eine Polarisierung der Piezolagen durch Beaufschlagung der Außenelektroden mit einem hohen elektrischen Feld (z. B. > 0,2 kV/mm) bei hohen Temperaturen oberhalb der Curietemperatur des keramischen Materials durchgeführt und durch Abkühlen unter weiterer Beaufschlagung durch das elektrische Feld wird die Ausrichtung von Domänen des keramischen Materials eingefroren, wobei das elektrische Feld in vorteilhafter Weise gemäß der Erfindung oszillierend ist.

Kern der Erfindung ist somit ein optimierter Heißpolprozess, der zu keiner Ausrichtung der eingangs erwähnten Defekten in der Piezokeramik führt, da das Polarisationsfeld oszillierend angelegt wird. Die Migration der eingangs erwähnten Defekte in der Piezokeramik ist ein diffusionsgesteuerter Vorgang und hängt in starkem Maß von der Stärke und der Zeit des angelegten Polarisationsfeldes sowie der Temperatur ab. Durch das erfindungsgemäß vorgeschlagene oszillierende Polungsfeld, bei dem eine oszillierende Spannung an die Außenelektroden angelegt wird, führt dies über den Zusammenhang E=U/d (E= elektrische Feldstärke, U= angelegte Spannung, d = Piezokeramik-Schichtdicke), zu einem oszillierenden Polungsfeld. Dadurch kann der Piezoaktor gepolt werden, ohne dass (geladene) Defekte diffundieren können. Dabei ist es besonders vorteilhaft, wenn das Polarisationsfeld bei hohen Temperaturen (entsprechend einer hohen Defektbeweglichkeit!) eine große Amplitude bzw. Frequenz ausweist, die mit zunehmender Abkühlung immer schwächer wird.

Die Spannung U, die zu einem Polarisationsfeld E führt, kann dabei unipolar oder bipolar angelegt werden. Die Frequenz des oszillierenden elektrischen Feldes kann entweder konstant oder variabel sein. Es ist auch in vorteilhafter Weise möglich, dass die elektrische Spannung zur Erzeugung des oszillierenden elektrischen Feldes eine ansteigende Medianspannung aufweist. Auf einfache Weise kann dabei durch eine sogennante insitu-Messung der Kleinsignalkapazität und durch eine Steuerung der zuvor genannten Parameter ein individueller Piezoaktor beim Heißpolarisieren auf einen Ziel-(dh.) Polungszustand hin optimiert werden.

Eine bevorzugte Anwendung des erfindungsgemäßen Piezoaktors ergibt sich, wenn der Piezoaktor Bestandteil eines Piezoinjektors zur Steuerung der Kraftstoffeinspritzung bei einem Verbrennungsmotor ist.

### Kurze Beschreibung der Zeichnung

Ein Ausführungsbeispiel der Erfindung ist im Folgenden näher beschrieben. Es zeigen:
Figur 1 eine schematische Darstellung eines Piezoaktors mit Piezolagen aus Piezokeramik zur Verwendung in einem Piezoinjektor in einem Längsschnitt.
Figur 2 eine schematische Darstellung der Ausrichtung von Defekten beim Heißpolarisieren.
Figur 3 einen Verlauf der zur Polarisierung angelegten oszillierenden Spannung über der Zeit mit abnehmender Amplitude bei der Abkühlung.
Figur 4 einen Verlauf der zur Polarisierung angelegten oszillierenden Spannung über der Zeit mit ansteigender Medianspannung.

### Ausführungsformen der Erfindung

Ein in Figur 1 schematisch dargestellter Piezoaktor 1 umfasst mehrere als Mehrlagenaufbau übereinandergestapelte Piezoelemente 2, die jeweils aus Piezolagen 3 aus Piezokeramik und diese einschließende Innenelektroden 4 und 5 bestehen. Die Innenelektroden 4 und 5 der Piezoelemente 2 sind mit Außenelektroden 6 und 7 wechselseitig an eine Spannungsquelle 8, zum Beispiel in der Größenordnung von 200 V, angeschlossen, die unter Ausnutzung des Piezoeffekts bei Anlage der elektrischen Spannung eine mechanische Reaktion des Piezoaktors 1 in Richtung des Mehrlagenaufbaus bewirken.

In Figur 2 ist gezeigt, wie Defektausrichtungen 10 im an sich bekannten keramischen Gefüge der Piezolagen 3 nach dem Sinterprozess bei der Herstellung des Piezoaktors 1 nach einer Polarisierung aussehen könnten. Durch ein angelegtes Feld 11 beim sogenannten Heißpolen richten sich die Defekte im keramischen Gefüge (1) bis (9) so aus, dass sich innerhalb des Gefüges Bereiche ausbilden, die dauerhaft ein elektrisches Feld, welches entgegengesetzt zum Feld 11 wirkt, aufweisen. Diese intrinsischen Felder werden auch als Depolarisationsfelder, bzw. als Domänen bezeichnet.

Wird der Piezoaktor 1 zum Beispiel in einem Piezoinjektor mit einer elektrischen Spannung beaufschlagt, so wird das entstehende Feld durch diese intrinsische Depolarisationsfgelder geschwächt und der Piezoaktor 1 erreicht nicht das theoretisch mögliche Arbeitsvermögen. Durch einen optimierten Spannungsverlauf beim Heißpolen können daher die internen Depolarisationsfelder vermieden oder zumindest verringert werden.

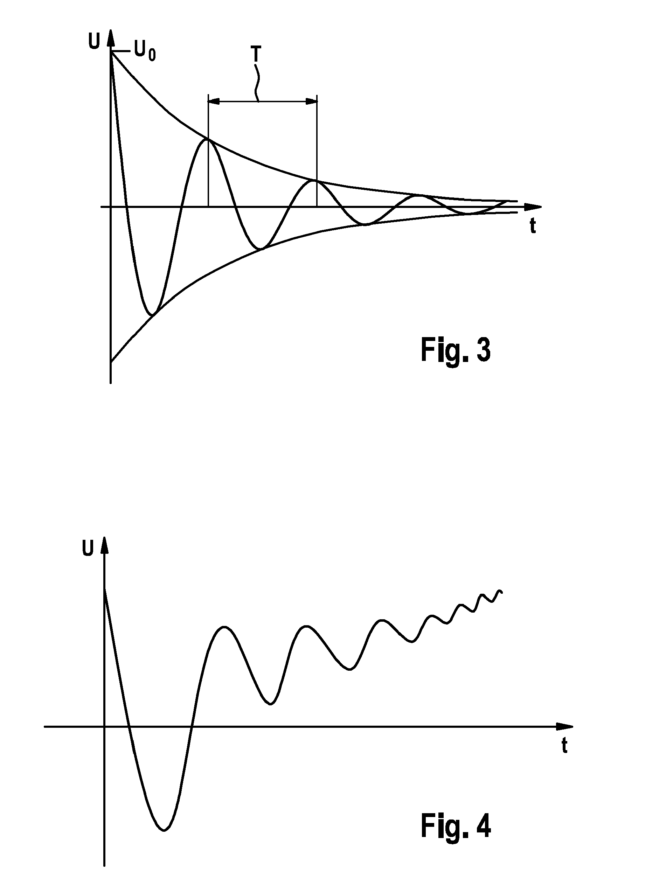

Aus dem Verlauf der Spannung U über der Zeit t nach Figur 3 ist erkennbar, dass hier mit der oszillierenden Spannung U ein Polarisationsfeld erzeugt wird, das bei hohen Temperaturen (entsprechend einer hohen Defektbeweglichkeit!) eine große Amplitude aufweist, die mit zunehmender Abkühlung immer schwächer wird. Die Frequenz wird bei dieser Ausführungsform nicht verändert.

In Figur 4 ist gezeigt, dass der Verlauf der Spannung U über der Zeit t eine ansteigende Medianspannung aufweist.

## Patentansprüche

1. Verfahren zur Herstellung eines Piezoaktors mit einem Mehrlagenaufbau aus Piezoelementen (2), die jeweils aus Piezolagen (3) aus keramischem Material bestehen, die zwischen Innenelektroden (4,5) eingefasst sind und die in Richtung des Lagenaufbaus und der Wirkrichtung des Piezoaktors (1) über Außenelektroden (6,7) abwechselnd mit einer unterschiedlichen Polarität einer elektrischen Spannung beaufschlagbar sind, bei dem eine Polarisierung der Piezolagen (3) durch Beaufschlagung der Außenelektroden (6,7) mit einem elektrischen Feld (11) bei Temperaturen oberhalb der Curietemperatur des keramischen Materials durchgeführt wird und durch Abkühlen unter weiterer Beaufschlagung durch das elektrische Feld (11) die Ausrichtung von Domänen des keramischen Materials eingefroren wird, wobei das elektrische Feld (11) oszillierend ist.

2. Verfahren nach Anspruch 1, **dadurch gekennzeichnet, dass** das oszillierende elektrische Feld (11) mit steigender Temperatur eine steigende Amplitude und/oder steigende Frequenz und bei fallender Temperatur eine abnehmende Amplitude und/oder abnehmende Frequenz aufweist.

3. Verfahren nach Anspruch 1 oder 2, **dadurch gekennzeichnet, dass** die elektrische Spannung zur Erzeugung des oszillierenden elektrischen Feldes (11) unipolar ist.

4. Verfahren nach Anspruch 1 oder 2, **dadurch gekennzeichnet, dass** die elektrische Spannung zur Erzeugung des oszillierenden elektrischen Feldes (11) bipolar ist.

5. Verfahren nach Anspruch 1 oder 2, **dadurch gekennzeichnet, dass** die Frequenz des oszillierenden elektrischen Feldes (11) konstant ist.

6. Verfahren nach Anspruch 1 oder 2, **dadurch gekennzeichnet, dass** die Frequenz des oszillierenden elektrischen Feldes (11) variabel ist.

7. Verfahren nach Anspruch 1 oder 2, **dadurch gekennzeichnet, dass** die elektrische Spannung zur Erzeugung des oszillierenden elektrischen Feldes (11) eine ansteigende Medianspannung aufweist.

## Claims

1. Method for producing a piezo actuator with a multilayered structure of piezo elements (2), which in each case consist of piezo layers (3) of ceramic material, which are enclosed between inner electrodes (4, 5) and to which an electrical voltage can be applied alternatingly with a different polarity in the direction of the layer structure and the effective direction of the piezo actuator (1) by way of outer electrodes (6, 7), in which a polarization of the piezo layers (3) is carried out by applying to the outer electrodes (6, 7) an electrical field (11) at temperatures above the Curie temperature of the ceramic material, and the alignment of domains of the ceramic material is frozen by cooling while continuing to apply the electrical field (11), the electrical field (11) being oscillating.

2. Method according to Claim 1, **characterized in that** the oscillating electrical field (11) has an increasing amplitude and/or increasing frequency with increasing temperature and has a decreasing amplitude and/or decreasing frequency with decreasing temperature.

3. Method according to Claim 1 or 2, **characterized in that** the electrical voltage for generating the oscillating electrical field (11) is unipolar.

4. Method according to Claim 1 or 2, **characterized in that** the electrical voltage for generating the oscillating electrical field (11) is bipolar.

5. Method according to Claim 1 or 2, **characterized in that** the frequency of the oscillating electrical field (11) is constant.

6. Method according to Claim 1 or 2, **characterized in that** the frequency of the oscillating electrical field (11) is variable.

7. Method according to Claim 1 or 2, **characterized in that** the electrical voltage for generating the oscillating electrical field (11) has an increasing median voltage.

## Revendications

1. Procédé de fabrication d'un actionneur piézoélectrique ayant une structure multicouche constituée d'éléments piézoélectriques (2), lesquels se composent respectivement de couches piézoélectriques (3) en matériau céramique qui sont enchâssées entre des électrodes internes (4, 5) et qui peuvent être exposées en alternance à une polarité différente d'une tension électrique par le biais d'électrodes externes (6, 7) en direction de la structure en couches et du sens d'action de l'actionneur piézoélectrique (1), selon lequel une polarisation des couches piézoélectriques (3) est effectuée en exposant les électrodes externes (6, 7) à un champ électrique (11) à des températures supérieures à la température de Curie du matériau céramique et l'orientation de domaines du matériau céramique est gelée par refroidissement en poursuivant l'exposition au champ électrique (11), le champ électrique (11) étant oscillant.

2. Procédé selon la revendication 1, **caractérisé en ce que** le champ électrique (11) oscillant présente une amplitude croissante et/ou une fréquence croissante lorsque la température augmente et une amplitude décroissante et/ou une fréquence décroissante lorsque la température diminue.

3. Procédé selon la revendication 1 ou 2, **caractérisé en ce que** la tension électrique servant à générer le champ électrique (11) oscillant est unipolaire.

4. Procédé selon la revendication 1 ou 2, **caractérisé en ce que** la tension électrique servant à générer le champ électrique (11) oscillant est bipolaire.

5. Procédé selon la revendication 1 ou 2, **caractérisé en ce que** la fréquence du champ électrique (11) oscillant est constante.

6. Procédé selon la revendication 1 ou 2, **caractérisé en ce que** la fréquence du champ électrique (11) oscillant est variable.

7. Procédé selon la revendication 1 ou 2, **caractérisé en ce que** la tension électrique servant à générer le champ électrique (11) oscillant présente une tension médiane croissante.
